# EUROPEAN PATENT APPLICATION

(11) **EP 4 072 013 A1**
(43) Date of publication of application: **12.10.2022**
(21) Application number: 20879416.4
(22) Date of filing: 06.05.2020
(51) Int. Cl.: H03H 9/02, H03H 9/17

(54) **BULK ACOUSTIC RESONATOR WITH ELECTRODE HAVING VOID LAYER, FILTER, AND ELECTRONIC DEVICE**

(30) Priority: 23.10.2019 CN 201911009262; 11.12.2019 CN 201911267553
(71) Applicant: ROFS MICROSYSTEM (TIANJIN) CO., LTD., Tianjin 300462 (CN)
(72) Inventor: PANG, Wei, Tianjin 300072 (CN); ZHANG, Wei, Tianjin 300462 (CN); HAO, Long, Tianjin 300072 (CN); XU, Yang, Tianjin 300462 (CN); YANG, Qingrui, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/088707
(87) International publication number: WO 2021/077717

(57) **Abstract**

The present disclosure relates to a bulk acoustic wave resonator. The resonator includes: a base, an acoustic lens, a bottom electrode, a top electrode, and a piezoelectric layer arranged between the bottom electrode and the top electrode, wherein the bottom electrode and/or the top electrode is a gap electrode; the gap electrode has a gap layer; the side of the gap layer that is close to the piezoelectric layer is provided with a first electrode layer, and the side of the gap layer that is away from the piezoelectric layer is provided with a second electrode layer; the gap layer is arranged between the first electrode layer and the second electrode layer in the thickness direction of the resonator, and the corresponding first electrode layer and second electrode layer are electrically connected to each other; and the resistance of the first electrode layer is greater than the resistance of the second electrode layer, and/or the acoustic impedance of the first electrode layer is greater than the acoustic impedance of the second electrode layer. The present disclosure further relates to a filter having the resonator, and an electronic device having the filter or the resonator.

## Description

### TECHNICAL FIELD

Embodiments of the present disclosure relate to the field of semiconductors, and in particular, to a bulk acoustic wave resonator, a filter having the resonator, and an electronic device having the resonator or the filter.

### BACKGROUND

Electronic components have been widely used as basic elements of electronic devices, applications of which include mobile phones, vehicles, household appliances and etc. In addition, technologies such as artificial intelligence, Internet of Things and 5G communications that will change the world in the future still need to rely on the electronic components.

The electronic components can exert different characteristics and advantages according to different working principles. Among all electronic components, components that use a piezoelectric effect (or an inverse piezoelectric effect) for working are an important type of electronic components. Piezoelectric devices have very wide applications. A film bulk acoustic resonator (FBAR, also referred to as Bulk Acoustic Wave Resonator, BAW), as an important member of the piezoelectric devices, is important in the field of communications. In particular, FBAR filters have an increasing market in the field of radio frequency (RF) filters. The FBAR has excellent characteristics such as small size, high resonant frequency, high quality factor, large power capacity, and good roll-off effect. The filters of FBAR are gradually replacing traditional surface acoustic wave (SAW) filters and ceramic filters. The filters of FBAR play a huge role in the field of wireless communication radio frequency, and the high sensitivity advantage thereof can be applied to biological, physical, medical and other sensing fields.

The structural main body of the film bulk acoustic wave resonator is a "sandwich" structure composed of electrode-piezoelectric film-electrode, that is, a piezoelectric material is sandwiched between two metal electrode layers. By inputting a sinusoidal signal between the two electrodes, the FBAR converts the input electrical signal into mechanical resonance by the inverse piezoelectric effect, and converts the mechanical resonance into an electrical signal for output by the piezoelectric effect.

The rapid development of communication technologies requires a continuous increase in the working frequency of a filter. For example, the frequency of a 5G communication frequency band (sub-6G) is between 3 GHz and 6 GHz, which is higher than that of 4G and other communication technologies. As for the bulk acoustic wave resonator and the filter, the high working frequency means that the film thickness, especially the film thickness of an electrode, needs to be further reduced. However, a main negative effect caused by the decrease in the film thickness of the electrode is a decrease in a Q value of the resonator resulting from an increase in the electrical loss, especially a decrease in the Q value at a series resonance point and its nearby frequencies. Correspondingly, the performance of a bulk acoustic wave filter with a high working frequency is greatly deteriorated with the decrease in the Q value of the bulk acoustic wave resonator.

### SUMMARY

The present disclosure is provided to alleviate or solve at least one aspect of the above problems in the related art.

According to one aspect of embodiments of the present disclosure, a bulk acoustic wave resonator is provided and includes a substrate, an acoustic lens, a bottom electrode, a top electrode, and a piezoelectric layer provided between the bottom electrode and the top electrode. The bottom electrode and/or the top electrode is a gap electrode, and the gap electrode has a gap layer. The gap layer is provided with a first electrode layer at a side of the gap layer close to the piezoelectric layer, and the gap layer is further provided with a second electrode layer at a side of the gap layer away from the piezoelectric layer. The gap layer is arranged between the first electrode layer and the second electrode layer in a thickness direction of the resonator, and the first electrode layer and the second electrode layer are electrically connected to each other. The first electrode layer has a resistance greater than a resistance of the second electrode layer, and/or the first electrode layer has an acoustic impedance greater than an acoustic impedance of the second electrode layer.

The embodiments of the present disclosure also relate to a filter including the above bulk acoustic wave resonator.

The embodiments of the present disclosure also relate to an electronic device including the above filter or the above resonator.

### BRIEF DESCRIPTION OF DRAWINGS

The following description and drawings can help understand these and other features and advantages in various embodiments of the present disclosure. The same reference signs in the drawings always indicate the same components.
FIG. 1 is a schematic top view of a bulk acoustic wave resonator according to an exemplary embodiment of the present disclosure.
FIG. 2 is a schematic sectional view along A1-A2 in FIG. 1 according to an exemplary embodiment of the present disclosure, in which an electrode layer located close to a piezoelectric layer has a single-layer structure.
FIG. 3 is a schematic sectional view along A1-A2 in FIG. 1 according to another exemplary embodiment of the present disclosure, in which an electrode layer located close to a piezoelectric layer has a double-layer structure.
FIG. 4 is a schematic sectional view along A1-A2 in FIG. 1 according to another exemplary embodiment of the present disclosure, in which an electrode layer arranged away from a piezoelectric layer has of a double-layer structure.
FIG. 5 is a schematic sectional view along A1-A2 in FIG. 1 according to another exemplary embodiment of the present disclosure, in which two electrode layers of a gap electrode each have a double-layer structure.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as a limitation to the present disclosure.

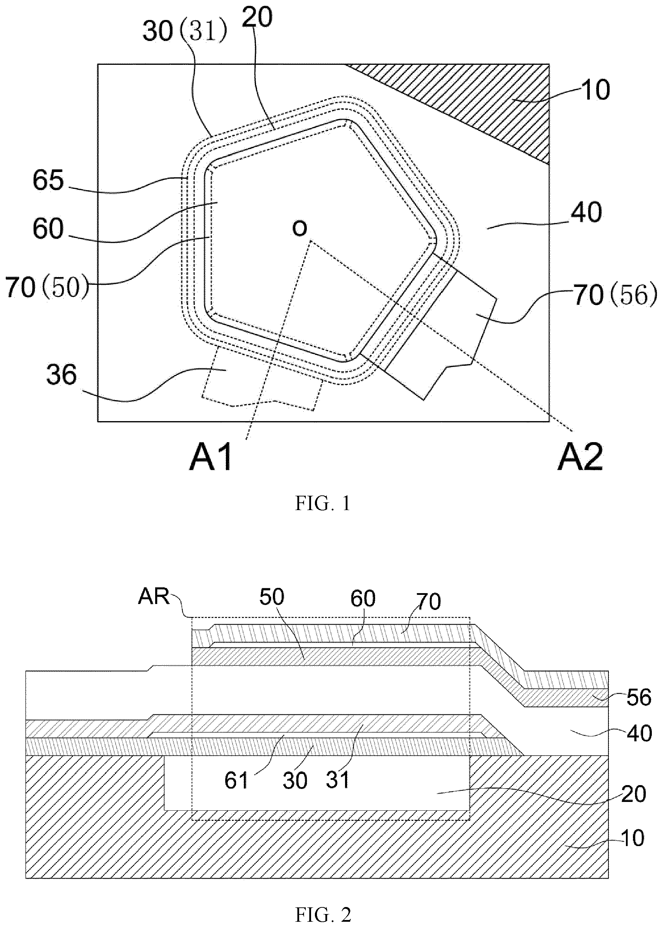

FIG. 1 is a schematic top view of a bulk acoustic wave resonator according to an exemplary embodiment of the present disclosure. FIG. 2 is a schematic sectional view along A1-A2 in FIG. 1 according to an exemplary embodiment of the present disclosure, in which an electrode layer arranged close to a piezoelectric layer has a single-layer structure. In FIG. 1 and FIG. 2, the reference signs are described as follows:
10: a substrate, which is made of silicon (high-resistance silicon), gallium arsenide, sapphire, quartz or the like;
20: an acoustic lens, which may be a cavity 20 as shown in FIGS. 2-5, or may employ a Bragg reflection layer or other equivalent forms;
30: a first bottom electrode including a pin portion, which is made of a low resistance material, and may be specifically made of aluminum, copper, gold, silver or the like, or an alloy thereof;
31: a second bottom electrode including a pin portion, which is made of a low acoustic loss (corresponding to high acoustic impedance) material, and may be specifically made of molybdenum, ruthenium, titanium, tungsten, platinum, iridium, osmium or the like, or an alloy thereof;
40: a piezoelectric film layer, which may be made of aluminum nitride (AlN), zinc oxide (ZnO), lead zirconate titanate (PZT), lithium niobate (LiNbO₃), quartz, potassium niobate (KNbO₃), lithium tantalate (LiTaO₃) or the like, and may contain rare earth element doped materials with a certain atomic ratio of the above materials;
50: a first top electrode including a pin portion 56, which is made of a low acoustic loss (corresponding to high acoustic impedance) material, and may be specifically made of molybdenum, ruthenium, titanium, tungsten, platinum, iridium, osmium or the like, or an alloy thereof;
60, 61: air gaps formed in a gap electrode; and
70: a second top electrode including a pin portion, which is made of a low resistance material, and may be specifically made of aluminum, copper, gold, silver or the like, or an alloy thereof.

It should be noted that the air gap forms a gap layer. However, in the present disclosure, the gap layer may be a vacuum gap layer except for an air gap layer, or may be a gap layer filled with other gas medium.

The gap layer may be provided in the top electrode, in the bottom electrode, or in the top electrode and the bottom electrode. FIG. 1 shows an embodiment in which both the top electrode and the bottom electrode are both provided with gap layers.

In addition, although it is not shown in the figures, the top electrode 70 may be covered with a passivation layer to prevent the electrodes from being oxidized by air.

In the present disclosure, the electrode provided with the gap layer is a gap electrode. Although not shown, in the case where the bottom electrode is a gap electrode, the gap layer of which may also replace the acoustic lens cavity 20 to serve as a reflector.

In the present disclosure, a high acoustic impedance metal material means that an acoustic impedance of a metal material is greater than 30 MRayls (further, greater than 50 MRayls), and a low electrical loss metal material or a low resistance metal material means that a resistance of the metal material is lower than 3.5×10⁻⁸ Qm.

Optionally, the air gap has a height in a range of 50 Å to 10000 Å. Further, the height of the air gap is greater than a typical amplitude (about 10 nm) of the resonator, for example, the height of the air gap is in a range of 100 Å to 5000 Å, which facilitate to decouple the top electrode 70 from a resonator cavity when the resonator operates at a high power, in which the resonator cavity is a composite structure formed by the top electrode 50, the piezoelectric layer 40, and the bottom electrode 30 in the present embodiment.

When the resonator is operating, an alternating electric field is applied to the piezoelectric layer 40 through the electrodes. Due to the coupling and mutual conversion of acoustic and electrical energy, current flows through the electrodes. Since the top electrode of the present embodiment has a double-layer electrode parallel structure, the electrical loss of the resonator is effectively reduced. Under the excitation of the alternating electric field, the piezoelectric layer generates acoustic waves. When the acoustic waves are conducted upwardly to an interface between the air gap 60 in the top electrode and the electrode layer 50, the energy of the acoustic waves will be reflected back to the piezoelectric layer 40 due to a great acoustic impedance mismatching degree between the air and the electrodes, and will not enter the electrode layer 70. On one hand, the electrode structure containing the air gap in the present disclosure significantly reduces the electrical loss of the resonator, i.e. increases a Q value at and near a series resonant frequency. On the other hand, the air gap provides an acoustic isolation function on the top electrode 70, thereby substantially avoiding negative effects, such as changes in the resonant frequency and an electromechanical coupling coefficient, of the electrode layer 70 on the performance of the resonator.

In the present disclosure, the gap layer is provided in the top electrode and/or bottom electrode of the bulk acoustic wave resonator. The air gap in the electrode effectively reflects the acoustic waves, thereby greatly reducing the energy of the acoustic waves entering an additional electrode on a side away from a piezoelectric film or the piezoelectric layer. Accordingly, this can effectively suppress or eliminate negative effects of the additional electrode caused by participating in acoustic vibration. In addition, upper and lower layers of electrodes enclosing the air gap may form a parallel circuit structure, which can effectively reduce the electrical loss of the resonator and improve the Q value of the resonator, especially the Q value at a series resonance point and its nearby frequencies.

Therefore, the additional electrode (such as, an electrode layer arranged away from the piezoelectric layer) is acoustically decoupled from the resonant cavity of the resonator due to the presence of the air gap since most of acoustic waves are reflected back to the resonant cavity at the air gap and do not enter the additional electrode. Other key parameters (such as the resonant frequency and the electromechanical coupling coefficient) other than the Q value of the resonator are not affected by the additional electrode and parameter changes.

Compared with a structure in which the air gap is located between the piezoelectric layer and the electrode, the present disclosure has the advantages that since parasitic series capacitance caused by the air gap is avoided, the electromechanical coupling coefficient kt² of the resonator will not deteriorate. Compared with a structure in which a temperature compensation interlayer (e.g., silicon dioxide) is located between two layers of electrodes, the air gap or vacuum gap of the present disclosure maintains the resonant frequency of the resonator unchanged. In this way, other key parameters (such as, the Q value and the electromechanical coupling coefficient) will not deteriorate, and the Q value at the series resonance point and its nearby frequencies is increased on the contrary.

In the present disclosure, when the acoustic lens structure is provided in the substrate and no gap layer is provided in the bottom electrode, an effective region of the resonator is an overlapping region of the top electrode, the piezoelectric layer, the bottom electrode, and the acoustic lens in the thickness direction of the resonator.

In the present disclosure, when the gap layer is provided in the bottom electrode, the effective region of the resonator is an overlapping region of the top electrode, the bottom electrode, the piezoelectric layer, and the gap layer of the bottom electrode in the thickness direction of the resonator.

In the present disclosure, electrodes of different materials are used to jointly form an air gap structure, the advantages of a plurality of materials are simultaneously exerted and their disadvantages are avoided. On one hand, a part of the materials may be used to reduce the impedance of the resonator, and on the other hand, another part of the materials may be used to reduce the acoustic loss.

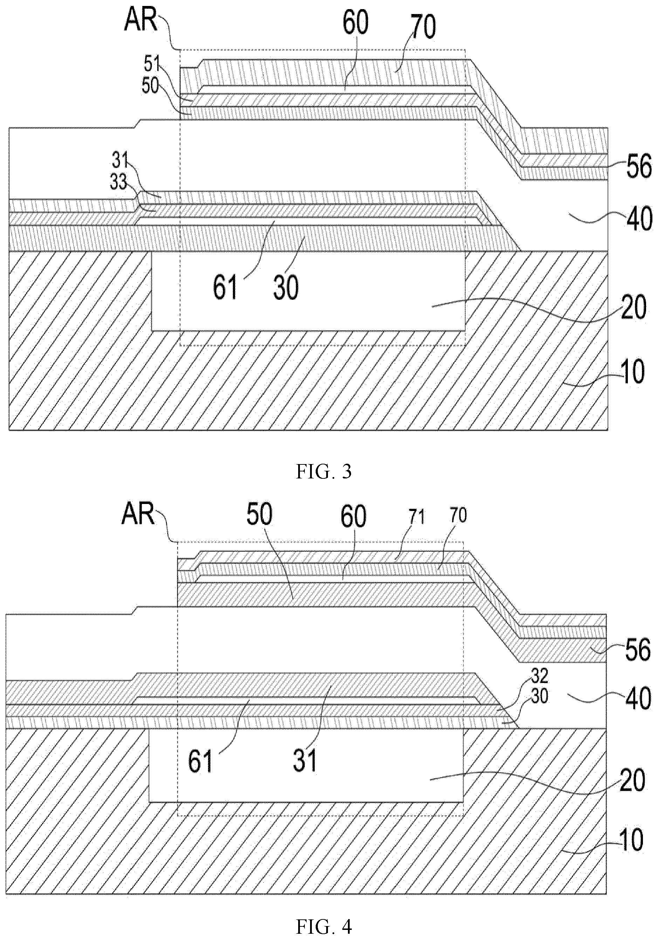

FIG. 3 is a schematic sectional view along A1-A2 in FIG. 1 according to another exemplary embodiment of the present disclosure, in which an electrode layer arranged close to a piezoelectric layer has a double-layer structure.

In the structure of the resonator shown in FIG. 3, the second bottom electrode is divided into two layers. A second bottom electrode layer (corresponding to 31) arranged close to the piezoelectric layer is made of a low acoustic loss material, such as a high acoustic impedance material. The low acoustic loss material specifically includes at least one selected from a group consisting of molybdenum, ruthenium, titanium, tungsten, platinum, iridium, osmium and the like, and an alloy thereof. A second bottom electrode layer (corresponding to 33) arranged away from the piezoelectric layer is made of a low resistance material, which specifically includes at least one selected from a group consisting of aluminum, copper, gold, silver and the like, and an alloy thereof. Accordingly, in FIG. 3, the first top electrode is divided into two layers, in which the first top electrode 50 is arranged close to the piezoelectric layer and is made of a low acoustic loss material. The low acoustic loss material specifically includes at least one selected from a group consisting of molybdenum, ruthenium, titanium, tungsten, platinum, iridium, osmium and the like, and an alloy thereof. The first top electrode 51 arranged away from the piezoelectric layer is made of a low resistance material, which specifically includes at least one selected from a group consisting of aluminum, copper, gold, silver and the like, and an alloy thereof. In addition, the first bottom electrode 30 and the second top electrode 70 are also made of a low resistance material, but the specific materials are not necessarily the same as those of the second bottom electrode 33 and the first top electrode 51. The structure of FIG. 3 increases the usage ratio of the low resistance material, thereby further reducing the impedance of the resonator.

FIG. 4 is a schematic sectional view along A1-A2 in FIG. 1 according to another exemplary embodiment of the present disclosure, in which an electrode layer arranged away from a piezoelectric layer has a double-layer structure. In the structure of the resonator shown in FIG. 4, the first bottom electrode is divided into two layers. The first bottom electrode 32 arranged close to the piezoelectric layer is made of a low acoustic loss material, which specifically includes at least one selected from a group consisting of molybdenum, ruthenium, titanium, tungsten, platinum, iridium, osmium and the like, and an alloy thereof. The first bottom electrode 30 arranged away from the piezoelectric layer is made of a low resistance material, which specifically includes at least one selected from a group consisting of aluminum, copper, gold, silver and the like, and an alloy thereof. Similarly, the second top electrode is divided into two layers. The second top electrode 70 arranged close to the piezoelectric layer is made of a low acoustic loss material, which specifically includes at least one selected from a group consisting of molybdenum, ruthenium, titanium, tungsten, platinum, iridium, osmium and the like, and an alloy thereof. The second top electrode layer 71 arranged away from the piezoelectric layer is made of a low resistance material, which specifically includes at least one selected from a group consisting of aluminum, copper, gold, silver and the like, and an alloy thereof. In addition, the second bottom electrode 31 and the first top electrode 50 are also made of a low acoustic loss material, but the specific materials are not necessarily the same as those of the first bottom electrode 32 and the first top electrode 71. The structure of FIG. 4 can enhance the structural strength of the electrode, thereby preventing the electrodes for forming the air gap from being attached to each other.

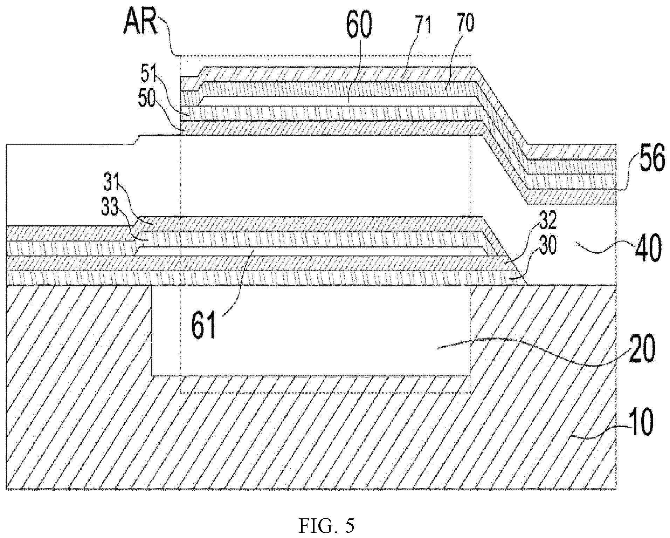

FIG. 5 is a schematic sectional view along A1-A2 in FIG. 1 according to another exemplary embodiment of the present disclosure, in which two electrode layers of a gap electrode each have a double-layer structure. In the structure of the resonator structure of FIG. 5, the first and second bottom electrodes and the first and second top electrodes each have a double-layer material structure. The electrode 31 and the electrode 50 are made of a low acoustic loss material, which specifically includes at least one selected from a group consisting of molybdenum, ruthenium, titanium, tungsten, platinum, iridium, osmium and the like, and an alloy thereof. However, the materials of the electrode 31 and the electrode 50 are not necessarily made of the same material. The electrode 33 and the electrode 51 are made of a low resistance material, which specifically includes at least one selected from a group consisting of aluminum, copper, gold, silver and the like, and an alloy thereof. However, the materials of the electrode 33 and the electrode 51 are not necessarily made of the same material. The electrode 32 and the electrode 70 are made of a low acoustic loss material, which specifically includes at least one selected from a group consisting of molybdenum, ruthenium, titanium, tungsten, platinum, iridium, osmium and the like, and an alloy thereof. However, the materials of the electrode 32 and the electrode 70 are not necessarily made of the same material. The electrode 30 and the electrode 71 are made of a low resistance material, which specifically includes at least one selected from a group consisting of aluminum, copper, gold, silver or the like, or an alloy thereof. However, the materials of the electrode 30 and the electrode 71 are not necessarily made of the same material. In addition, variable materials may be employed. For example, the materials of the electrode 30 and the electrode 32 may be interchanged, and the same changing manner may be applied to the electrode 70 and the electrode 71.

In the present disclosure, a mentioned numerical range may not only be endpoint values, but may also be a mean value of the endpoint values or other values, which all fall within the scope of the present disclosure.

As can be appreciated by those skilled in the art, the bulk acoustic wave resonator according to the present disclosure can be used to form a filter.

Based on the above description, the present disclosure provides the following technical solutions.
1. A bulk acoustic wave resonator includes:
   a substrate;
   an acoustic lens;
   a bottom electrode;
   a top electrode; and
   a piezoelectric layer provided between the bottom electrode and the top electrode,
   wherein
   the bottom electrode and/or the top electrode is a gap electrode, the gap electrode has a gap layer, the gap layer is provided with a first electrode layer at a side of the gap layer close to the piezoelectric layer, the gap layer is further provided with a second electrode layer at a side of the gap layer away from the piezoelectric layer, the gap layer is arranged between the first electrode layer and the second electrode layer in a thickness direction of the resonator, and the first electrode layer and the second electrode layer are electrically connected to each other; and
   the first electrode layer has a resistance greater than a resistance of the second electrode layer, and/or the first electrode layer has an acoustic impedance greater than an acoustic impedance of the second electrode layer.
2. The resonator according to 1, wherein
   the first electrode layer has a stiffness greater than a stiffness of the second electrode layer.
3. The resonator according to 1, wherein
   the gap layer is an air gap layer or a vacuum gap layer.
4. The resonator according to 1, wherein
   the gap layer has a thickness in a range of 50 Å to 10000 Å.
5. The resonator according to 4, wherein
   the thickness of the gap layer is in a range of 100 Å to 5000 Å.
6. The resonator according to any one of 1-5, wherein
   the first electrode layer is made of a material including molybdenum, ruthenium, titanium, tungsten, platinum, iridium or osmium, or an alloy thereof; and
   the second electrode layer is made of a material including aluminum, copper, gold or silver, or an alloy thereof.
7. The resonator according to any one of 1-6, wherein
   the first electrode layer includes a first sublayer and a second sublayer, which are stacked in the thickness direction of the resonator, and the first sublayer is arranged closer to the piezoelectric layer than the second sublayer.
8. The resonator according to 7, wherein
   the first sublayer has a resistance greater than a resistance of the second sublayer; and/or
   the first sublayer has an acoustic impedance greater than an acoustic impedance of the second sublayer.
9. The resonator according to 8, wherein
   the first sublayer is made of a material including molybdenum, ruthenium, titanium, tungsten, platinum, iridium or osmium, or an alloy thereof; and
   the second sublayer is made of a material including aluminum, copper, gold or silver, or an alloy thereof.
10. The resonator according to 9, wherein
   the material of the second sublayer is the same as a material of the second electrode layer.
11. The resonator according to 8, wherein
   the resistance of the second sublayer is less than 3.5×10⁻⁸ Qm; and/or
   the acoustic impedance of the first sublayer is greater than 30 MRayls.
12. The resonator according to 11, wherein
   the acoustic impedance of the first sublayer is greater than 50 MRayls.
13. The resonator according to 1, wherein
   the resistance of the second electrode layer is less than 3.5×10⁻⁸ Qm; and/or
   the acoustic impedance of the first electrode layer is greater than 30 MRayls.
14. The resonator according to 13, wherein
   the acoustic impedance of the first electrode layer is greater than 50 MRayls.
15. The resonator according to any one of 1-14, wherein
   the second electrode layer includes a third sublayer and a fourth sublayer, which are stacked in the thickness direction of the resonator, and the third sublayer is arranged closer to the piezoelectric layer than the fourth sublayer.
16. The resonator according to 15, wherein
   the third sublayer has a resistance different from a resistance of the fourth sublayer; and/or
   the third sublayer has an acoustic impedance different from an acoustic impedance of the fourth sublayer.
17. The resonator according to 16, wherein
   one of the third sublayer and the fourth sublayer is made of a material including molybdenum, ruthenium, titanium, tungsten, platinum, iridium or osmium, or an alloy thereof; and
   another one of the third sublayer and the fourth sublayer is made of a material including aluminum, copper, gold or silver, or an alloy thereof.
18. A filter includes the bulk acoustic wave resonator according to any one of 1-17.
19. An electronic device includes the filter according to 18 or the resonator according to any one of 1-17.

Although the embodiments of the present disclosure have been shown and described, it will be understood by those skilled in the art that changes can be made to these embodiments without departing from the principles and spirit of the present disclosure, and the scope of the present disclosure is determined by the appended claims and their equivalents

## Claims

1. A bulk acoustic wave resonator, comprising:
a substrate;
an acoustic lens;
a bottom electrode;
a top electrode; and
a piezoelectric layer provided between the bottom electrode and the top electrode,
wherein the bottom electrode and/or the top electrode is a gap electrode, the gap electrode has a gap layer, the gap layer is provided with a first electrode layer at a side of the gap layer close to the piezoelectric layer, the gap layer is further provided with a second electrode layer at a side of the gap layer away from the piezoelectric layer, the gap layer is arranged between the first electrode layer and the second electrode layer in a thickness direction of the resonator, and the first electrode layer and the second electrode layer are electrically connected to each other; and
wherein the first electrode layer has a resistance greater than a resistance of the second electrode layer, and/or the first electrode layer has an acoustic impedance greater than an acoustic impedance of the second electrode layer.

2. The resonator according to claim 1, wherein the first electrode layer has a stiffness greater than a stiffness of the second electrode layer.

3. The resonator according to claim 1, wherein the gap layer is an air gap layer or a vacuum gap layer.

4. The resonator according to claim 1, wherein the gap layer has a thickness in a range of 50 Å to 10000 Å.

5. The resonator according to claim 4, wherein the thickness of the gap layer is in a range of 100 Å to 5000 Å.

6. The resonator according to any one of claims 1-5, wherein the first electrode layer is made of a material comprising molybdenum, ruthenium, titanium, tungsten, platinum, iridium or osmium, or an alloy thereof; and
the second electrode layer is made of a material comprising aluminum, copper, gold or silver, or an alloy thereof.

7. The resonator according to any one of claims 1-6, wherein the first electrode layer comprises a first sublayer and a second sublayer, which are stacked in the thickness direction of the resonator, and the first sublayer is arranged closer to the piezoelectric layer than the second sublayer.

8. The resonator according to claim 7, wherein the first sublayer has a resistance greater than a resistance of the second sublayer; and/or
the first sublayer has an acoustic impedance greater than an acoustic impedance of the second sublayer.

9. The resonator according to claim 8, wherein the first sublayer is made of a material comprising molybdenum, ruthenium, titanium, tungsten, platinum, iridium or osmium, or an alloy thereof; and
the second sublayer is made of a material comprising aluminum, copper, gold or silver, or an alloy thereof.

10. The resonator according to claim 9, wherein the material of the second sublayer is the same as a material of the second electrode layer.

11. The resonator according to claim 8, wherein the resistance of the second sublayer is less than 3.5×10⁻⁸ Qm; and/or
the acoustic impedance of the first sublayer is greater than 30 MRayls.

12. The resonator according to claim 11, wherein the acoustic impedance of the first sublayer is greater than 50 MRayls.

13. The resonator according to claim 1, wherein the resistance of the second electrode layer is less than 3.5×10⁻⁸ Qm; and/or
the acoustic impedance of the first electrode layer is greater than 30 MRayls.

14. The resonator according to claim 13, wherein the acoustic impedance of the first electrode layer is greater than 50 MRayls.

15. The resonator according to any one of claims 1-14, wherein the second electrode layer comprises a third sublayer and a fourth sublayer, which are stacked in the thickness direction of the resonator, and the third sublayer is arranged closer to the piezoelectric layer than the fourth sublayer.

16. The resonator according to claim 15, wherein the third sublayer has a resistance different from a resistance of the fourth sublayer; and/or
the third sublayer has an acoustic impedance different from an acoustic impedance of the fourth sublayer.

17. The resonator according to claim 16, wherein one of the third sublayer and the fourth sublayer is made of a material comprising molybdenum, ruthenium, titanium, tungsten, platinum, iridium or osmium, or an alloy thereof; and
another one of the third sublayer and the fourth sublayer is made of a material comprising aluminum, copper, gold or silver, or an alloy thereof.

18. A filter, comprising the bulk acoustic wave resonator according to any one of claims 1-17.

19. An electronic device, comprising the filter according to claim 18 or the resonator according to any one of claims 1-17.
